# EUROPEAN PATENT SPECIFICATION

(11) **EP 3 589 460 B1**
(45) Date of publication and mention of the grant of the patent: **07.07.2021**
(21) Application number: 18711690.0
(22) Date of filing: 26.02.2018
(51) Int. Cl.: B25J 15/00, B25J 15/02, H05K 13/04

(54) **GRIPPING SYSTEM**
GREIFERSYSTEM
SYSTÈME DE PRÉHENSION

(30) Priority: 28.02.2017 CN 201710112539
(43) Date of publication of application: 08.01.2020
(73) Proprietor: Tyco Electronics (Shanghai) Co., Ltd., Pilot Free Trade Zone Shanghai (CN); Shenzhen AMI Technology Co. Ltd., Shenzhen Guangdong (CN)
(72) Inventor: DAI, Zhiyong, Shanghai (CN); HU, Lvhai, Shanghai (CN); LIU, Yun, Shanghai (CN); ZENG, Qinglong, Shanghai (CN); KANG, Wei, Shanghai (CN)
(74) Representative: Grünecker Patent- und Rechtsanwälte PartG mbB
(86) International application number: PCT/IB2018/051192
(87) International publication number: WO 2018/158670

(56) References cited:
- DE-B3-102012 219 127
- GB-A- 2 085 400
- JP-U- S56 157 781
- KR-B1- 101 307 954
- US-A- 5 102 287
- US-A- 5 481 794
- US-A1- 2015 001 867
- US-B1- 6 217 093

## Description

### BACKGROUND OF THE INVENTION

### Field of the Invention

Embodiments of the present disclosure relate to a gripping system, and more particularly to a gripping system adapted to grip a row of contacts.

### Description of the Related Art

In the prior art, a gripping system for gripping a row of contacts typically includes a single gripper, and the row of contacts are all gripped to the gripper. In the prior art, the gripper have a constant gripping pitch, and the pitch between adjacent contacts of the row of contacts may not be adjusted, once the row of contacts is clamped to a single gripper. For example, DE 102012219127 B3 relates to a handling device for workpieces, the handling device comprising multiple grippers, which are all attached to a support frame.

Therefore, in the prior art, when the pitch between adjacent contacts needs to be changed, it is necessary to change grippers with different gripping pitches, which leads to the complicated gripping operation of the contacts.

US 5,481,794 A relates to a device and method for simultaneously receiving objects (e.g. electrical contact elements) arranged in a first pattern by means of guided clamps and delivering said objects arranged in a second pattern.

JP S56157781 U discloses a mechanism for transporting multiple electronic components simultaneously to respective predetermined positions.

KR 101307954 B1 relates to a component transfer device with multiple pickers having an adjustable position value.

### SUMMARY OF THE INVENTION

The present disclosure has been made to overcome or alleviate at least one aspect of the above mentioned disadvantages.

At least one embodiment of the disclosure provides a gripping system which is adapted to grip a row of contacts and may simply adjust a pitch between adjacent contacts.

According to one aspect of the present disclosure, there is provided a gripping system, comprising: a gripping device comprising a row of grippers arranged in a first direction and adapted to grip a row of contacts; and a pitch adjustment device adapted to adjust a pitch between adjacent grippers of the row of grippers. The gripping device further comprises a support frame on which at least two grippers of the row of grippers are slidably attached; and a row of gripper supports arranged in a second direction perpendicular to the first direction, the row of grippers being attached on the row of gripper supports, respectively, and each gripper support of the row of gripper supports other than an outmost gripper support is slidably attached on the support frame; and the pitch adjustment device is adapted to drive the at least two adjacent grippers of the row of grippers to slide in the first direction, so as to adjust the pitch between the adjacent grippers, wherein the pitch adjustment device comprises: a first pushing mechanism adapted to push each gripper support of the row of gripper supports other than the outmost gripper support to slide in the first direction; and a first drive mechanism adapted to drive the first pushing mechanism to slide in the second direction.

According to an exemplary embodiment of the present disclosure, each gripper of the row of grippers other than an outmost gripper is slidably attached on the support frame; and the outmost gripper of the row of grippers is fixedly attached on the support frame.

According to another exemplary embodiment of the present disclosure, the gripping device further comprises: a row of sliding rails attached on the support frame, and each of the row of gripper supports other than the outmost gripper support is slidingly attached on a corresponding sliding rail.

According to another exemplary embodiment of the present disclosure, the outmost gripper support of the row of gripper supports is fixedly attached on the support frame.

According to another exemplary embodiment of the present disclosure, the gripping device further comprises: a row of mounting plates attached on the support frame, and the row of sliding rails are attached on the row of mounting plates respectively.

According to another exemplary embodiment of the present disclosure, the gripping system further comprises a base on which the gripping device is removably attached.

According to another exemplary embodiment of the present disclosure, a groove is formed on the support frame, and a projection fitted to the groove is formed on the base.

According to another exemplary embodiment of the present disclosure, the first pushing mechanism is slidably attached on the base and the first drive mechanism is attached on the base.

According to another exemplary embodiment of the present disclosure, the first pushing mechanism comprises: a bracket slidably attached on the base; and a plurality of drive blocks attached on the bracket. The first drive mechanism is adapted to drive the bracket to slide in the second direction so as to drive the plurality of drive blocks attached on the bracket to move in the second direction.

According to another exemplary embodiment of the present disclosure, a plurality of first tilting surface is formed on each drive block, and a second tilting surface cooperating with the first tilting surface is formed on a corresponding gripper support. The first tilting surface of each drive block is adapted to push against the second tilting surface of the corresponding gripper support and slide relative to the second tilting surface.

According to another exemplary embodiment of the present disclosure, the bracket comprises: a beam slidably attached on the base; and a frame attached on the beam wherein the plurality of drive blocks are removably attached on the frame.

According to another exemplary embodiment of the present disclosure, the first pushing mechanism further comprises: a slider on which the beam is attached; and a guiding rail attached on the base, wherein the slider is slidably attached on the guiding rail such that the bracket is slidable along the guiding rail.

According to another exemplary embodiment of the present disclosure, the first drive mechanism comprises a cylinder drive mechanism, a stepping motor drive mechanism or a servo motor drive mechanism.

According to another exemplary embodiment of the present disclosure, the gripping system further comprises an opening and closing control device adapted to control the row of grippers to open or close.

According to another exemplary embodiment of the present disclosure, each gripper comprises a lower gripping portion and an upper gripping portion pivotally attached on the lower gripping portion; and the opening and closing control device is adapted to open or close the gripper by pressing downwards or pushing upwards the upper gripping portion.

According to another exemplary embodiment of the present disclosure, the opening and closing control device comprises: a second pushing mechanism movably attached on the base of the gripping system; and a second drive mechanism adapted to drive the second pushing mechanism to move in the second direction, when the second drive mechanism drives the second pushing mechanism to move backwards in the second direction, the second pushing mechanism presses a rear end of the upper gripping portion of the gripper downwards such that the gripper is opened. When the second drive mechanism drives the second pushing mechanism to move forwards in the second direction, the second pushing mechanism pushes the rear end of the upper gripping portion of the gripper upwards so that the gripper is closed.

According to another exemplary embodiment of the present disclosure, the second pushing mechanism has an upper plate and a lower plate assembled together, the upper plate being provided with an upper lip, and the lower plate being provided with a lower lip; the rear end of the upper gripping portion of the gripper is located between the upper lip and the lower lip. When the second drive mechanism drives the second pushing mechanism to move backwards in the second direction, the upper lip presses the rear end of the upper gripping portion downwards such that the gripper is opened; and when the second drive mechanism drives the second pushing mechanism to move forwards in the second direction, the lower lip pushes the rear end of the upper gripping portion upwards so that the gripper is closed.

According to another exemplary embodiment of the present disclosure, a top tilting surface and a bottom tilting surface are formed on the rear end of the upper gripping portion. The upper lip is adapted to press against the top tilting surface of the upper gripping portion and to slide along the top tilting surface; and the lower lip is adapted to push against the bottom tilting surface of the upper gripping portion and to slide along the bottom tilting surface.

According to another exemplary embodiment of the present disclosure, the second drive mechanism comprises a cylinder drive mechanism, a stepping motor drive mechanism or a servo motor drive mechanism.

In the aforementioned various exemplary embodiments of the present disclosure, the gripping system comprises a row of grippers for gripping a row of contacts, and the pitch between adjacent grippers of the row of grippers is adjustable so that the pitch between adjacent contacts of the row of contacts gripped on the row of the grippers may be simply adjusted, simplifying the gripping operation of the contacts.

In addition, in some of the foregoing exemplary embodiments of the present disclosure, the gripping system further comprises an opening and closing control device for automatically opening and closing a row of grippers, thereby further simplifying the clamping operation of the contacts.

Other objects and advantages of the present disclosure will become apparent from the following description of the present disclosure, which may give a comprehensive understanding of the present disclosure, when taken in conjunction with the accompanying drawings.

### BRIEF DESCRIPTION OF THE DRAWINGS

The above and other features of the present disclosure will become more apparent by describing in detail exemplary embodiments thereof with reference to the accompanying drawings, in which:
Fig. 1 shows a perspective schematic view of a gripping system according to an exemplary embodiment of the present disclosure;
Fig. 2 shows a perspective schematic view of the gripping device of the gripping system shown in Fig. 1;
Fig. 3 shows another perspective schematic view of the gripping device of the gripping system shown in Fig. 1;
Fig. 4 shows a perspective schematic view of a pitch adjustment device of the gripping system shown in Fig. 1;
Fig.5 shows a perspective schematic view of a gripper of the gripping device of the gripping system shown in Fig. 1; and
Fig.6 shows a perspective schematic view of an opening and closing control device of the gripping system shown in Fig. 1.

### DETAILED DESCRIPTION OF PREFERRED EMBODIMENTS OF THE IVENTION

Exemplary embodiments of the present disclosure will be described hereinafter in detail with reference to the attached drawings, wherein the like reference numerals refer to the like elements. It should be understood that the description to the embodiments of the present disclosure in conjunction with the attached drawings is to convey a general concept of the present disclosure to the person of ordinary skill in the art, than to limit the present disclosure to the described exemplary embodiments.

Furthermore, in the following detailed description, for purposes of explanation, numerous specific details are set forth in order to provide a thorough understanding of the disclosed embodiments. It will be apparent, however, that one or more embodiments may be practiced without these specific details. In other instances, well-known structures and devices are schematically shown in order to simplify the drawing.

According to a general technical concept of the invention, there is provided a gripping device comprising a row of grippers arranged in a first direction and adapted to grip a row of contacts; and a pitch adjustment device adapted to adjust a pitch between adjacent grippers of the row of grippers. The gripping device further comprises a support frame on which at least two grippers of the row of grippers are slidably attached; and a row of gripper supports arranged in a second direction perpendicular to the first direction, the row of grippers being attached on the row of gripper supports, respectively, and each gripper support of the row of gripper supports other than an outmost gripper support is slidably attached on the support frame; and the pitch adjustment device is adapted to drive the at least two adjacent grippers of the row of grippers to slide in the first direction, so as to adjust the pitch between the adjacent grippers, wherein the pitch adjustment device comprises: a first pushing mechanism adapted to push each gripper support of the row of gripper supports other than the outmost gripper support to slide in the first direction; and a first drive mechanism adapted to drive the first pushing mechanism to slide in the second direction.

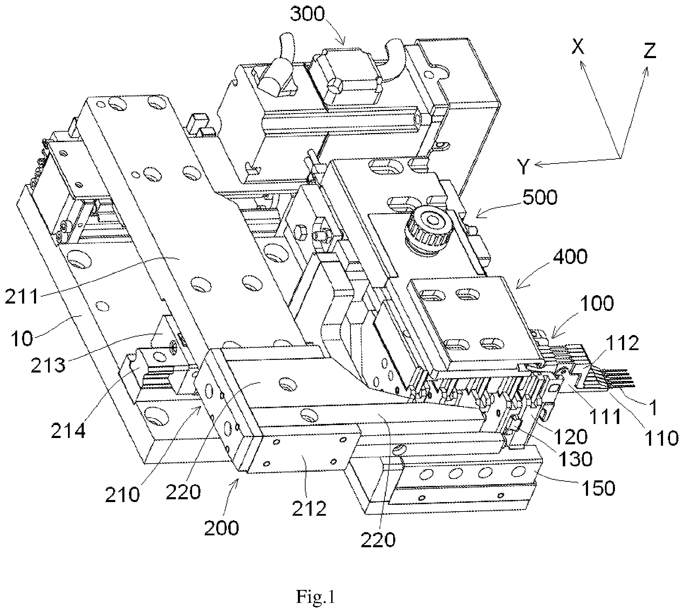

Fig. 1 shows a perspective schematic view of a gripping system according to an exemplary embodiment of the present disclosure.

As shown in Fig.1, in an illustrated embodiment, the gripping system mainly comprises a gripping device 100 and a pitch adjustment device 200, 300. The gripping device 100 comprises a row of grippers 110 arranged in a first direction X and adapted to grip a row of contacts 1. The pitch adjustment device 200, 300 is adapted to adjust a pitch between two adjacent grippers 110 of the row of grippers 110, such that the pitch between the adjacent contacts 1 of the row of contacts 1 gripped on the row of the grippers 110 may be adjusted.

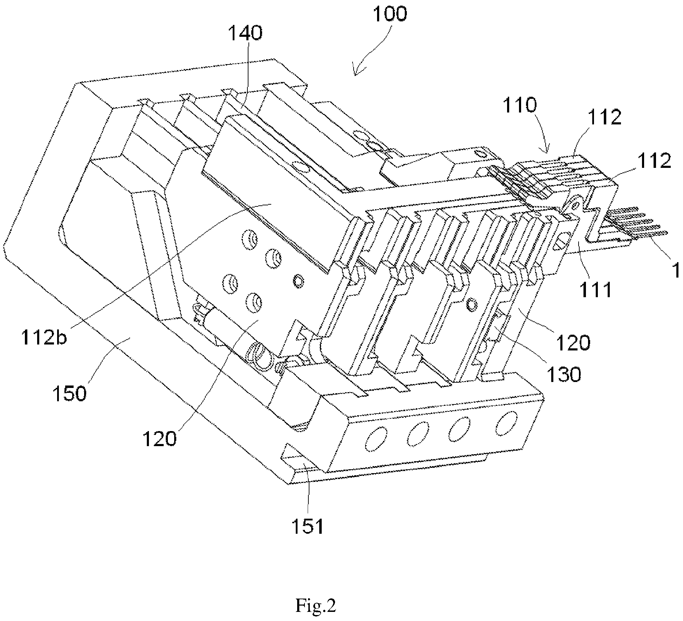

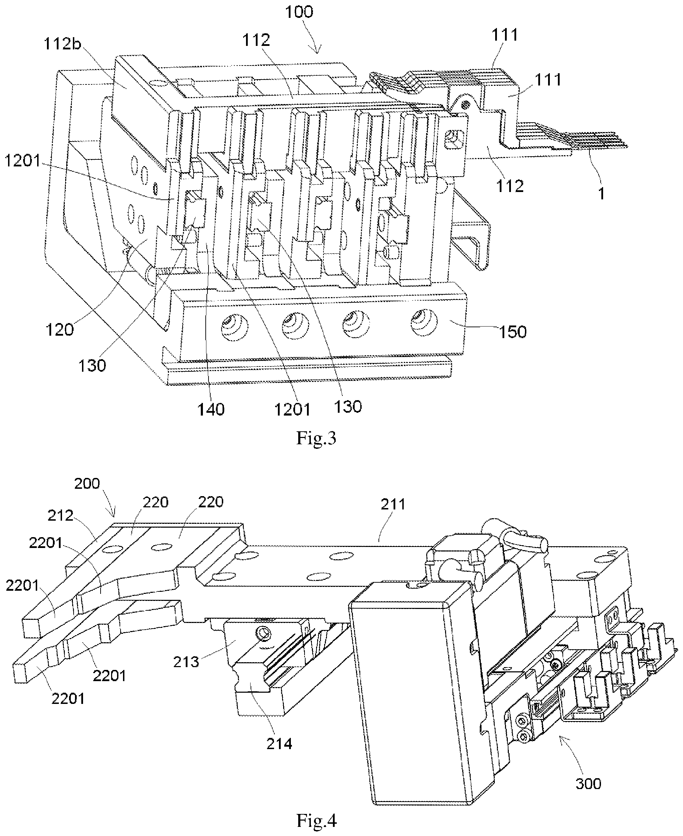

Fig. 2 shows a perspective schematic view of the gripping device 100 of the gripping system shown in Fig. 1; and Fig. 3 shows another perspective schematic view of the gripping device 100 of the gripping system shown in Fig. 1.

As shown in Figs. 1, 2 and 3, in the illustrated embodiment, the gripping device 100 further comprises a support frame 150. Each gripper 110 of the row of grippers 110 other than an outmost gripper 110 is slidably attached on the support frame 150. The outmost gripper 110 of the row of grippers 110 is fixedly attached on the support frame 150 and may not be moved. The pitch adjustment device 200, 300 is adapted to drive each gripper 110 of the row of grippers 110 other than the outmost gripper 110 to slide in the first direction X, so as to adjust the pitch between the adjacent grippers 110 of the row of grippers 110.

As shown in Figs. 1, 2 and 3, in the illustrated embodiment, the gripping device 100 further comprises a row of gripper supports 120. The row of gripper supports 120 are arranged in a second direction Y perpendicular to the first direction X, and the row of grippers 110 are attached on the row of gripper supports 120 respectively. As shown in Figs. 2 and 3, each gripper support 120 of the row of gripper supports 120 other than an outmost gripper support 120 is slidably attached on the support frame 150.

As shown in Figs. 2 and 3, in the illustrated embodiment, the gripping device 100 further comprises a row of sliding rails 130, which are attached on the support frame 150. Each gripper support 120 of the row of gripper supports 120 other than the outmost gripper support 120 is slidably attached on a corresponding one of the row of sliding rails 130. The outmost gripper support 120, for example the rightmost gripper support 120 in Fig. 2, of the row of gripper supports 120 is fixedly attached on the support frame 150 and may not be moved.

As shown in Figs. 2 and 3, in the illustrated embodiment, the gripping device 100 further comprises a row of mounting plates 140. The row of mounting plates 140 are attached on the support frame 150. The row of sliding rails 130 are attached on the row of mounting plates 140 respectively.

As shown in Figs. 1, 2 and 3, in the illustrated embodiment, the gripping system further comprises a base 10, on which the entire gripping device 100 is removably attached.

As shown in Figs. 1, 2 and 3, in the illustrated embodiment, a groove 151 is formed on the support frame 150, and a projection (not shown) fitted to the groove 151 is formed on the base 10.

Fig. 4 shows a perspective schematic view of the pitch adjustment device 200, 300 of the gripping system shown in Fig. 1.

As shown in Figs. 1 and 4, in the illustrated embodiment, the pitch adjustment device 200, 300 comprises a first pushing mechanism 200 and a first drive mechanism 300. The first pushing mechanism 200 is slidably attached on the base 10 and adapted to push each gripper support 120 of the row of gripper supports 120 other than the outmost gripper support 120 to slide in the first direction X. The first drive mechanism 300 is attached on the base 10 and adapted to drive the first pushing mechanism 200 to slide in the second direction Y.

As shown in Figs. 1 and 4, in the illustrated embodiment, the first pushing mechanism 200 comprises a bracket 210 and a plurality of drive blocks 220. The bracket 210 is slidably attached on the base 10. The plurality of drive blocks 220 are attached on the bracket 210. The first drive mechanism 300 is adapted to drive the bracket 210 to slide in the second direction Y so as to drive the plurality of drive blocks 220 attached on the bracket 210 to move in the second direction Y.

As shown in Figs. 3 and 4, in the illustrated embodiment, a plurality of first tilting surface 2201 is formed on each drive block 220, and a second tilting surface 1201 cooperated with the first tilting surface 2201 is formed on a corresponding gripper support 120. As shown in Figs. 1, 3 and 4, in the illustrated embodiment, the first tilting surface 2201 of each drive block 220 is adapted to push against the second tilting surface 1201 of the corresponding gripper support 120 and slide relative to the second tilting surface 1201, so that the corresponding gripper support 120 is driven to move in the second direction Y

As shown in Figs. 1 and 4, in the illustrated embodiment, the bracket 210 comprises a beam 211 and a frame 212. The beam 211 is slidably attached on the base 10. The frame 212 is attached on the beam 211. The plurality of drive blocks 220 are removably attached on the frame 212.

As shown in Figs. 1 and 4, in the illustrated embodiment, the first pushing mechanism 200 further comprises a slider 213 and a guiding rail 214. The beam 211 is attached on the slider 213. The guiding rail 214 is attached on the base 10. The slider 213 is slidably attached on the guiding rail 214 such that the bracket 210 is slidable along the guiding rail 214 in the second direction Y.

As shown in Figs. 1 and 4, in the illustrated embodiment, the first drive mechanism 300 comprises a cylinder drive mechanism, a stepping motor drive mechanism or a servo motor drive mechanism.

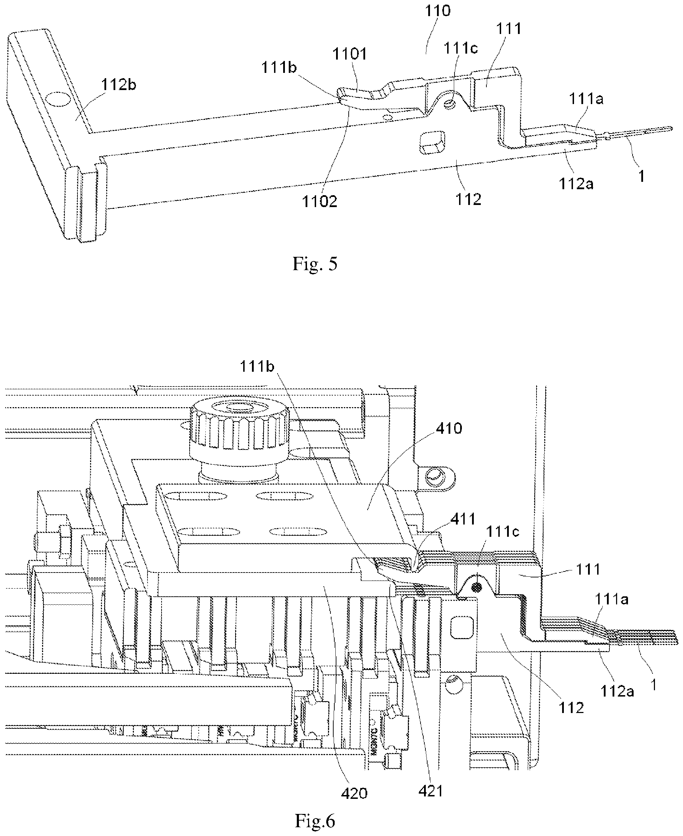

Fig.6 shows a perspective schematic view of an opening and closing control device 400, 500 of the gripping system shown in Fig. 1.

As shown in Figs. 1 and 6, in the illustrated embodiment, the gripping system further comprises an opening and closing control device 400, 500 adapted to control the row of grippers 110 to open or close.

Fig. 5 shows a perspective schematic view of a gripper 110 of the gripping device 100 of the gripping system shown in Fig. 1.

As shown in Figs. 1 and 5, in the illustrated embodiment, each gripper 110 comprises a lower gripping portion 112 and an upper gripping portion 111 pivotally attached on the lower gripping portion 112 such that the upper gripping portion 11 may rotate about a pivoting axis 111c. The lower gripping portion 112 is fixedly attached on a corresponding gripper support 120. As shown in Figs. 3 and 5, a rear end 112b of the lower gripping portion 112 is removably attached on the corresponding gripper support 120, so that the each gripper 110 may be moved in the first direction X together the corresponding gripper support 120.

When the bracket 210 is driven to slide in the second direction Y by the first drive mechanism 300, the plurality of first tilting surface 2201 of each drive block 220 push against the second tilting surface 1201 of the corresponding gripper support 120 sequentially from left to right in Fig. 1 and slide relative to the second tilting surface 1201. In this way, the corresponding gripper support 120 is driven to move in the first direction X. Since different first tilting surfaces 2201 having different heights in the first direction X are in contact with the second tilting surfaces 1201 of different gripper supports 120, respectively, during the bracket 210 is driven to slide in the second direction Y, the grippers 110 is driven to move in the first direction X by different distances. Accordingly, the contacts 1 held on the grippers move in the first direction X by the different distances, so that the pitch between two adjacent contacts of the row of contacts 1 is achieved.

Furthermore, by replacing the drive blocks 220 having different first tilting surfaces 2201, the pitch between two adjacent contacts of the row of contacts 1 may be adjusted.

As shown in Figs. 1, 5 and 6, in the illustrated embodiment, the opening and closing control device 400, 500 is adapted to open or close the gripper 110 by pressing downwards or pushing upwards the upper gripping portion 111 to release or grip the contacts 1.

As shown in Figs. 1, 5 and 6, in the illustrated embodiment, the opening and closing control device 400, 500 comprises a second pushing mechanism 400 and a second drive mechanism 500. The second pushing mechanism 400 is movably attached on the base 10 of the gripping system. The second drive mechanism 500 is adapted to drive the second pushing mechanism 400 to move in the second direction Y.

As shown in Figs. 5 and 6, in the illustrated embodiment, when the second drive mechanism 500 drives the second pushing mechanism 400 to move backwards (toward left side in Fig. 6) in the second direction Y, the second pushing mechanism 400 presses a rear end 111b of the upper gripping portion 111 of the gripper 110 downwards such that a front end 111a of the upper gripping portion 111 rotates upwards about the pivoting axis 111c with respect to a front end 112a of the lower gripping portion 112 and then the row of grippers 110 may be opened. When the row of grippers 110 is opened, the row of contacts 1 may be placed into the row of grippers 110.

As shown in Figs. 5 and 6, in the illustrated embodiment, when the second drive mechanism 500 drives the second pushing mechanism 400 to move forwards (toward right side in Fig. 6) in the second direction Y, the second pushing mechanism 400 pushes the rear end 111b of the upper gripping portion 111 of the gripper 110 upwards such that the front end 111a of the upper gripping portion 111 rotates downwards about the pivoting axis 111c with respect to the front end 112a of the lower gripping portion 112 and then the row of grippers 110 may be closed. When the row of grippers 110 is closed, the row of contacts 1 may be gripped and held therein.

As shown in Figs. 5 and 6, in the illustrated embodiment, the second pushing mechanism 400 has an upper plate 410 and a lower plate 420 assembled together. The upper plate 410 is provided with an upper lip 411, and the lower plate 420 is provided with a lower lip 421. The rear end 111b of the upper gripping portion 111 of the gripper 110 is located between the upper lip 411 and the lower lip 421.

As shown in Figs. 5 and 6, in the illustrated embodiment, when the second drive mechanism 500 drives the second pushing mechanism 400 to move backwards in the second direction Y, the upper lip 411 presses the rear end 111b of the upper gripping portion 111 downwards such that the gripper 110 is opened. When the second drive mechanism 500 drives the second pushing mechanism 400 to move forwards in the second direction Y, the lower lip 421 pushes the rear end 111b of the upper gripping portion 111 upwards so that the gripper 110 is closed.

As shown in Figs. 5 and 6, in the illustrated embodiment, a top tilting surface 1101 and a bottom tilting surface 1102 are formed on the rear end 111b of the upper gripping portion 111. The upper lip 411 is adapted to press the top tilting surface 1101 of the upper gripping portion 111 downwards and to slide along the top tilting surface 1101. The lower lip 421 is adapted to push the bottom tilting surface 1102 of the upper gripping portion 111 upwards and to slide along the bottom tilting surface 1102.

As shown in Fig. 1, in the illustrated embodiment, the second drive mechanism 500 comprises a cylinder drive mechanism, a stepping motor drive mechanism or a servo motor drive mechanism.

It should be appreciated for those skilled in this art that the above embodiments are all exemplary embodiments, and many modifications may be made to the above embodiments by those skilled in this art, and various features described in different embodiments may be freely combined with each other without conflicting in configuration or principle.

Although the present disclosure has been described with reference to the attached drawings, the embodiments disclosed in the attached drawings are intended to describe the preferred embodiments of the present disclosure exemplarily, but should not be construed as a limitation to the present disclosure.

Although several embodiments of the general concept of the present disclosure have been shown and described, it would be appreciated by those skilled in the art that various changes or modifications may be made in these embodiments without departing from the disclosure, the scope of which is defined in the claims.

As used herein, term "comprising" or "having" should be understood as not excluding other elements or steps, and term "a" or "an" should be understood as not excluding plural elements or steps. In addition, any reference numeral in claims should not be understood as the limitation of the scope of the present disclosure.

## Claims

1. A gripping system, comprising:
a gripping device (100) comprising a row of grippers (110) arranged in a first direction (X) and adapted to grip a row of contacts (1); and
a pitch adjustment device (200, 300) adapted to adjust a pitch between adjacent grippers (110) of the row of grippers (110),
wherein the gripping device (100) further comprises a support frame (150) on which at least two grippers of the row of grippers (110) are slidably attached; and
a row of gripper supports (120) arranged in a second direction (Y) perpendicular to the first direction (X), the row of grippers (110) being attached on the row of gripper supports (120), respectively, and each gripper support (120) of the row of gripper supports (120) other than an outmost gripper support (120) being slidably attached on the support frame (150); and wherein
the pitch adjustment device (200, 300) is adapted to drive the at least two grippers (110) of the row of grippers (110) to slide in the first direction (X), so as to adjust the pitch between adjacent grippers (110);
wherein the pitch adjustment device (200, 300) comprises:
a first pushing mechanism (200) adapted to push each gripper support (120) of the row of gripper supports (120) other than the outmost gripper support (120) to slide in the first direction (X); and
**characterized in that** the pitch adjustment device (200, 300) comprises
a first drive mechanism (300) adapted to drive the first pushing mechanism (200) to slide in the second direction (Y).

2. The gripping system according to claim 1, wherein:
each gripper of the row of grippers (110) other than an outmost gripper is slidably attached on the support frame (150); and
the outmost gripper of the row of grippers (110) is fixedly attached on the support frame (150).

3. The gripping system according to claim 1 or 2, wherein the gripping device (100) further comprises:
a row of sliding rails (130) attached on the support frame (150), wherein each of the row of gripper supports (120) other than the outmost gripper support (120) is slidingly attached on a corresponding sliding rail (130),;
the outmost gripper support (120) of the row of gripper supports (120) is fixedly attached on the support frame (150); and
the gripping device (100) further comprises:
a row of mounting plates (140) attached on the support frame (150), and wherein
the row of sliding rails (130) are attached on the row of mounting plates (140) respectively.

4. The gripping system according to any one of claims 1 to 3, wherein the gripping system further comprises:
a base (10) on which the gripping device (100) is removably attached; and wherein
a groove (151) is formed on the support frame (150), and a projection fitted to the groove (151) is formed on the base (10).

5. The gripping system according to claim 4, wherein the first pushing mechanism (200) is slidably attached on the base (10); and
the first drive mechanism (300) is attached on the base (10).

6. The gripping system according to claim 5, wherein:
the first pushing mechanism (200) comprises
a bracket (210) slidably attached on the base (10); and
a plurality of drive blocks (220) attached on the bracket (210),
wherein the first drive mechanism (300) is adapted to drive the bracket (210) to slide in the second direction (Y) so as to drive the plurality of drive blocks (220) attached on the bracket (210) to move in the second direction (Y).

7. The gripping system according to claim 6, wherein:
a plurality of first tilting surface (2201) is formed on each drive block (220), and
a second tilting surface (1201) cooperating with the first tilting surface (2201) is formed on a corresponding gripper support (120); and
the first tilting surface (2201) of each drive block (220) is adapted to push against the second tilting surface (1201) of the corresponding gripper support (120) and slide relative to the second tilting surface (1201).

8. The gripping system of claim 6, wherein the bracket (210) comprises:
a beam (211) slidably attached on the base (10); and
a frame (212) attached on the beam (211),
wherein the plurality of drive blocks (220) are removably attached on the frame (212).

9. The gripping system of claim 8, wherein the first pushing mechanism (200) further comprises:
a slider (213) on which the beam (211) is attached; and
a guiding rail (214) attached on the base (10),
wherein the slider (213) is slidably attached on the guiding rail (214) such that the bracket (210) is slidable along the guiding rail (214).

10. The gripping system according to any one of claims 1 to 9, wherein the gripping system further comprises:
an opening and closing control device (400, 500) adapted to control the row of grippers (110) to open or close.

11. The gripping system according to claim 10, wherein:
each gripper (110) comprises a lower gripping portion (112) and an upper gripping portion (111) pivotally attached on the lower gripping portion (112); and
the opening and closing control device (400, 500) is adapted to open or close the gripper (110) by pressing downwards or pushing upwards the upper gripping portion (111).

12. The gripping system according to claim 11, wherein the opening and closing control device (400, 500) comprises:
a second pushing mechanism (400) movably attached on the base (10); and
a second drive mechanism (500) adapted to drive the second pushing mechanism (400) to move in the second direction (Y),
wherein when the second drive mechanism (500) drives the second pushing mechanism (400) to move backwards in the second direction (Y), the second pushing mechanism (400) presses a rear end (111b) of the upper gripping portion (111) of the gripper (110) downwards such that the gripper (110) is opened; and
when the second drive mechanism (500) drives the second pushing mechanism (400) to move forwards in the second direction (Y), the second pushing mechanism (400) pushes the rear end (111b) of the upper gripping portion (111) of the gripper (110) upwards so that the gripper (110) is closed.

13. The gripping system according to claim 12, wherein:
the second pushing mechanism (400) has an upper plate (410) and a lower plate (420) assembled together, the upper plate (410) being provided with an upper lip (411), and the lower plate (420) being provided with a lower lip (421) ;
the rear end (111b) of the upper gripping portion (111) of the gripper (110) is located between the upper lip (411) and the lower lip (421);
when the second drive mechanism (500) drives the second pushing mechanism (400) to move backwards in the second direction (Y), the upper lip (411) presses the rear end (111b) of the upper gripping portion (111) downwards such that the gripper (110) is opened;
when the second drive mechanism (500) drives the second pushing mechanism (400) to move forwards in the second direction (Y), the lower lip (421) pushes the rear end (111b) of the upper gripping portion (111) upwards so that the gripper (110) is closed.

14. The gripping system according to claim 13, wherein:
a top tilting surface (1101) and a bottom tilting surface (1102) are formed on the rear end (111b) of the upper gripping portion (111);
the upper lip (411) is adapted to press against the top tilting surface (1101) of the upper gripping portion (111) and to slide along the top tilting surface (1101);
the lower lip (421) is adapted to push against the bottom tilting surface (1102) of the upper gripping portion (111) and to slide along the bottom tilting surface (1102).

## Patentansprüche

1. Greifsystem, das umfasst:
eine Greifvorrichtung (100), die eine Reihe von Greifern (110) umfasst, die in einer ersten Richtung (X) angeordnet und zum Greifen einer Reihe von Kontakten (1) eingerichtet sind; sowie
eine Abstands-Einstellvorrichtung (200, 300), die zum Einstellen eines Abstandes zwischen benachbarten Greifern (110) der Reihe von Greifern (110) eingerichtet ist,
wobei die Greifvorrichtung (100) des Weiteren einen Tragerahmen (150) umfasst, an dem wenigstens zwei Greifer der Reihe von Greifern (110) verschiebbar angebracht sind; und
eine Reihe von Greifer-Trägern (120), die in einer zweiten Richtung (Y) senkrecht zu der ersten Richtung (X) angeordnet sind, wobei die Reihe von Greifern (110) jeweils an der Reihe von Greifer-Trägern (120) angebracht ist und jeder Greifer-Träger (120) der Reihe von Greifer-Trägern (120) mit Ausnahme eines äußersten Greifer-Trägers (120) verschiebbar an dem Tragerahmen (150) angebracht ist; und
die Abstands-Einstellvorrichtung (200, 300) so eingerichtet ist, dass sie die wenigstens zwei Greifer (110) der Reihe von Greifern (110) zum Verschieben in der ersten Richtung (X) antreibt, um so den Abstand zwischen benachbarten Greifern (110) einzustellen;
wobei die Abstands-Einstellvorrichtung (200, 300) umfasst:
einen ersten Drückmechanismus (200), der so eingerichtet ist, dass er jeden Greifer-Träger (120) der Reihe von Greifer-Trägern (120) mit Ausnahme des äußersten Greifer-Trägers (120) zum Verschieben in der ersten Richtung (X) drückt; und
**dadurch gekennzeichnet, dass** die Abstands-Einstellvorrichtung (200, 300) umfasst:
einen ersten Antriebsmechanismus (300), der so eingerichtet ist, dass er den ersten Drückmechanismus (200) zum Verschieben in der zweiten Richtung (Y) antreibt.

2. Greifsystem nach Anspruch 1, wobei:
jeder Greifer der Reihe von Greifern (110) mit Ausnahme eines äußersten Greifers verschiebbar an dem Tragerahmen (150) angebracht ist; und
der äußerste Greifer der Reihe von Greifern (110) fest an dem Tragerahmen (150) angebracht ist.

3. Greifsystem nach Anspruch 1 oder 2, wobei die Greifvorrichtung (100) des Weiteren umfasst:
eine Reihe von Gleitschienen (130), die an dem Tragerahmen (150) angebracht sind,
wobei
jede der Reihe von Greifer-Trägern (120) mit Ausnahme des äußersten Greifer-Trägers (120) gleitend an einer entsprechenden Gleitschiene (130) angebracht ist;
der äußerste Greifer-Träger (120) der Reihe von Greifer-Trägern (120) fest an dem Tragerahmen (150) angebracht ist; und
die Greifvorrichtung (100) des Weiteren umfasst:
eine Reihe von Montageplatten (140), die an dem Tragerahmen (150) angebracht sind, und wobei
die Reihe von Gleitschienen (130) jeweils an der Reihe von Montageplatten (140) angebracht sind.

4. Greifsystem nach einem der Ansprüche 1 bis 3, wobei das Greifsystem des Weiteren umfasst:
einen Sockel (10), an dem die Greifvorrichtung (100) abnehmbar angebracht ist; und wobei
eine Nut (151) an dem Tragerahmen (150) ausgebildet ist, und ein in die Nut (151) passender Vorsprung an dem Sockel (10) ausgebildet ist.

5. Greifsystem nach Anspruch 4, wobei der erste Drückmechanismus (200) verschiebbar an dem Sockel (10) angebracht ist; und
der erste Antriebsmechanismus (300) an dem Sockel (10) angebracht ist.

6. Greifsystem nach Anspruch 5, wobei:
der erste Drückmechanismus (200) umfasst:
eine Halterung (210), die verschiebbar an dem Sockel (10) angebracht ist; und
eine Vielzahl von Antriebsblöcken (220), die an der Halterung (210) angebracht sind,
wobei der erste Antriebsmechanismus (300) so eingerichtet ist, dass er die Halterung (210) zum Verschieben in der zweiten Richtung (Y) antreibt, um die an der Halterung (210) angebrachte Vielzahl von Antriebsblöcken (220) zum Bewegen in der zweiten Richtung (Y) anzutreiben.

7. Greifsystem nach Anspruch 6, wobei:
eine Vielzahl erster Neigungsflächen (2201) an jedem Antriebsblock (220) ausgebildet ist, und
eine zweite Neigungsfläche (1201), die mit der ersten Neigungsfläche (2201) zusammenwirkt, an einem entsprechenden Greifer-Träger (120) ausgebildet ist; und
die erste Neigungsfläche (2201) jedes Antriebsblocks (220) so eingerichtet ist, dass sie auf die zweite Neigungsfläche (1201) des entsprechenden Greifer-Trägers (120) drückt und relativ zu der zweiten Neigungsfläche (1201) gleitet.

8. Greifsystem nach Anspruch 6, wobei die Halterung (210) umfasst:
einen Träger (211), der verschiebbar an dem Sockel (10) angebracht ist; und
einen Rahmen (212), der an dem Träger (211) angebracht ist,
wobei die Vielzahl von Antriebsblöcken (220) abnehmbar an dem Rahmen (212) angebracht ist.

9. Greifsystem nach Anspruch 8, wobei der erste Drückmechanismus (200) des Weiteren umfasst:
einen Gleiter (213), an dem der Träger (211) angebracht ist; und
eine Führungsschiene (214), die an dem Sockel (10) angebracht ist,
wobei der Gleiter (213) verschiebbar so an der Führungsschiene (214) angebracht ist, dass die Halterung (210) entlang der Führungsschiene (214) verschoben werden kann.

10. Greifsystem nach einem der Ansprüche 1 bis 9, wobei das Greifsystem des Weiteren umfasst:
eine Vorrichtung (400, 500) zum Steuern von Öffnen und Schließen, die so eingerichtet ist, dass sie die Reihe von Greifern (110) zum Öffnen oder Schließen steuert.

11. Greifsystem nach Anspruch 10, wobei:
jeder Greifer (110) einen unteren Greifabschnitt (112) sowie einen schwenkbar an dem unteren Greifabschnitt (112) angebrachten oberen Greifabschnitt (111) umfasst; und
die Vorrichtung (400, 500) zum Steuern von Öffnen und Schließen so eingerichtet ist, dass sie den Greifer (110) öffnet und schließt, indem sie den oberen Greifabschnitt (111) nach unten drückt oder nach oben drückt.

12. Greifsystem nach Anspruch 11, wobei die Vorrichtung (400, 500) zum Steuern von Öffnen und Schließen umfasst:
einen zweiten Drückmechanismus (400), der beweglich an dem Sockel (10) angebracht ist; sowie
einen zweiten Antriebsmechanismus (500), der so eingerichtet ist, dass er den zweiten Drückmechanismus (400) zum Bewegen in der zweiten Richtung (Y) antreibt.
wobei,
wenn der zweite Antriebsmechanismus (500) den zweiten Drückmechanismus (400) antreibt, um ihn in der zweiten Richtung (Y) rückwärts zu bewegen, der zweite Drückmechanismus (400) das hintere Ende (111b) des oberen Greifabschnitts (111) des Greifers (110) nach unten drückt, so dass der Greifer (110) geöffnet wird; und
wenn der zweite Antriebsmechanismus (500) den zweiten Drückmechanismus (400) antreibt, um ihn in der zweiten Richtung (Y) vorwärts zu bewegen, der zweite Drückmechanismus (400) das hintere Ende (111b) des oberen Greifabschnitts (111) des Greifers (110) nach oben drückt, so dass der Greifer (110) geschlossen wird.

13. Greifsystem nach Anspruch 12, wobei:
der zweite Drückmechanismus (400) eine obere Platte (410) und eine untere Platte (420) aufweist, die zusammengesetzt sind, wobei die obere Platte (410) mit einer oberen Lippe (411) versehen ist und die untere Platte (420) mit einer unteren Lippe (421) versehen ist;
das hintere Ende (111b) des oberen Greifabschnitts (111) des Greifers (110) sich zwischen der oberen Lippe (411) und der unteren Lippe (421) befindet;
wenn der zweite Antriebsmechanismus (500) den zweiten Drückmechanismus (400) antreibt, um ihn in der zweiten Richtung (Y) rückwärts zu bewegen, die obere Lippe (411) das hintere Ende (111b) des oberen Greifabschnitts (111) nach unten drückt, so dass der Greifer (110) geöffnet wird;
wenn der zweite Antriebsmechanismus (500) den zweiten Drückmechanismus (400) antreibt, um ihn in der zweiten Richtung (Y) vorwärts zu bewegen, die untere Lippe (421) das hintere Ende (111b) des oberen Greifabschnitts (111) nach oben drückt, so dass der Greifer (110) geschlossen wird.

14. Greifsystem nach Anspruch 13, wobei:
eine obere Neigungsfläche (1101) und eine untere Neigungsfläche (1102) an dem hinteren Ende (111b) des oberen Greifabschnitts (111) ausgebildet sind;
die obere Lippe (411) so eingerichtet ist, dass sie auf die obere Neigungsfläche (1101) des oberen Greifabschnitts (111) drückt und an der oberen Neigungsfläche (1101) entlang gleitet;
die untere Lippe (421) so eingerichtet ist, dass sie auf die untere Neigungsfläche (1102) des oberen Greifabschnitts (111) drückt und an der unteren Neigungsfläche (1102) entlang gleitet.

## Revendications

1. Système de préhension comprenant :
un dispositif de préhension (100) comportant une rangée de préhenseurs (110) agencés dans une première direction (X) et adaptés pour saisir une rangée de contacts (1) ; et
un dispositif d'ajustement de niveau (200, 300) adapté pour ajuster le niveau entre des préhenseurs adjacents (110) de la rangée de préhenseurs (110),
dans lequel
le dispositif de préhension (100) comprend en outre un châssis de support (150) sur lequel au moins deux préhenseurs de la rangée de préhenseurs (110) sont montés de manière coulissante ; et
une rangée de supports de préhenseur (120) agencés dans une deuxième direction (Y) perpendiculaire à la première direction (X), la rangée de préhenseurs (110) étant respectivement montée sur la rangée de supports de préhenseur (120), et chaque support de préhenseur (120) de la rangée de supports de préhenseur (120) autre que le support de préhenseur le plus externe (120) étant monté de manière coulissante sur le châssis de support (150) ; et dans lequel
le dispositif d'ajustement de niveau (200, 300) est adapté pour actionner lesdits au moins deux préhenseurs (110) de la rangée de préhenseurs (110) pour coulisser dans la première direction (X), de manière à ajuster le niveau entre les préhenseurs adjacents (110) ;
dans lequel le dispositif d'ajustement de niveau (200, 300) comprend :
un premier mécanisme de poussée (200) adapté pour pousser chaque support de préhenseur (120) de la rangée de supports de préhenseur (120) autre que le support de préhenseur le plus externe (120) pour coulisser dans la première direction (X) ; et
**caractérisé en ce que** le dispositif d'ajustement de niveau (200, 300) comprend un premier mécanisme d'actionnement (300) adapté pour actionner le premier mécanisme de poussée (200) pour coulisser dans la deuxième direction (Y).

2. Système de préhension selon la revendication 1, dans lequel :
chaque préhenseur de la rangée de préhenseurs (110) autre que le préhenseur le plus externe est monté de manière coulissante sur le châssis de support (150) ; et
le préhenseur le plus externe de la rangée de préhenseurs (110) est monté de manière fixe sur le châssis de support (150).

3. Système de préhension selon la revendication 1 ou 2, dans lequel le dispositif de préhension (100) comprend en outre :
une rangée de rails coulissants (130) montés sur le châssis de support (150), dans lequel chaque support de la rangée de supports de préhenseur (120) autre que le support de préhenseur le plus externe (120) est monté de manière coulissante sur un rail coulissant correspondant (130) ;
le support de préhenseur le plus externe (120) de la rangée de supports de préhenseur (120) est monté de manière fixe sur le châssis de support (150) ; et
le dispositif de préhension (100) comprend en outre :
une rangée de plaques de montage (140) montées sur le châssis de support (150), et dans lequel les rails de la rangée de rails coulissants (130) sont respectivement montés sur les plaques de la rangée de plaques de montage (140) .

4. Système de préhension selon l'une quelconque des revendications 1 à 3, dans lequel le système de préhension comprend en outre :
une base (10) sur laquelle le dispositif de préhension (100) est monté de manière amovible ;
et dans lequel une rainure (151) est formée sur le châssis de support (150), et une projection insérée dans la rainure (151) est formée sur la base (10).

5. Système de préhension selon la revendication 4, dans lequel
le premier mécanisme de poussée (200) est monté sur la base (10) de manière coulissante ; et
le premier mécanisme d'actionnement (300) est monté sur la base (10).

6. Système de préhension selon la revendication 5, dans lequel :
le premier mécanisme de poussée (200) comprend
une fixation (210) montée de manière coulissante sur la base (10) ; et
une pluralité de blocs d'actionnement (220) montés sur la fixation (210),
dans lequel le premier mécanisme d'actionnement (300) est adapté pour actionner la fixation (210) pour coulisser dans la deuxième direction (Y) de manière à actionner la pluralité de blocs d'actionnement (220) montés sur la fixation (210) pour coulisser dans la deuxième direction (Y) .

7. Système de préhension selon la revendication 6, dans lequel :
une première surface inclinable (2201) est formée sur chaque bloc d'actionnement (220), et
une deuxième surface inclinable (1201) qui coopère avec la première surface inclinable (2201) est formée sur un support de préhenseur correspondant (120) ; et
la première surface inclinable (2201) de chaque bloc d'actionnement (220) est adaptée pour pousser contre la deuxième surface inclinable (1201) du support de préhenseur correspondant (120) et pour coulisser par rapport à la deuxième surface inclinable (1201).

8. Système de préhension selon la revendication 6, dans lequel la fixation (210) comprend :
une poutre (211) montée de manière coulissante sur la base (10) ; et
un châssis (212) monté sur la poutre (211),
dans lequel les blocs de la pluralité de blocs d'actionnement (220) sont montés de manière amovible sur le châssis (212).

9. Système de préhension selon la revendication 8, dans lequel le premier mécanisme de poussée (200) comprend en outre :
un coulisseau (213) sur lequel la poutre (211) est montée ; et
un rail de guidage (214) monté sur la base (10),
dans lequel le coulisseau (213) est monté de manière coulissante sur le rail de guidage (214) de telle sorte que la fixation (210) peut coulisser le long du rail de guidage (214) .

10. Système de préhension selon l'une quelconque des revendications 1 à 9, dans lequel le système de préhension comprend en outre :
un dispositif de contrôle d'ouverture et de fermeture (400, 500) adapté pour contrôler l'ouverture ou la fermeture de la rangée de préhenseurs (110).

11. Système de préhension selon la revendication 10, dans lequel :
chaque préhenseur (110) comprend une portion de préhension inférieure (112) et une portion de préhension supérieure (111) montée de manière pivotante sur la portion de préhension inférieure (112) ; et
le dispositif de contrôle d'ouverture et de fermeture (400, 500) est adapté pour ouvrir ou fermer le préhenseur (110) en poussant la portion de préhension supérieure (111) vers le bas ou vers le haut.

12. Système de préhension selon la revendication 11, dans lequel le dispositif de contrôle d'ouverture et de fermeture (400, 500) comprend :
un deuxième mécanisme de poussée (400) monté sur la base (10) de manière mobile ; et
un deuxième mécanisme d'actionnement (500) adapté pour actionner le deuxième mécanisme de poussée (400) pour le déplacer dans la deuxième direction (Y),
dans lequel
quand le deuxième mécanisme d'actionnement (500) actionne le deuxième mécanisme de poussée (400) pour le déplacer en arrière dans la deuxième direction (Y), le deuxième mécanisme de poussée (400) pousse une extrémité arrière (111b) de la portion de préhension supérieure (111) du préhenseur (110) vers le bas de telle sorte que le préhenseur (110) est ouvert ; et
quand le deuxième mécanisme d'actionnement (500) actionne le deuxième mécanisme de poussée (400) pour le déplacer vers l'avant dans la deuxième direction (Y), le deuxième mécanisme de poussée (400) pousse l'extrémité arrière (111b) de la portion de préhension supérieure (111) du préhenseur (110) vers le haut de telle sorte que le préhenseur (110) est fermé.

13. Système de préhension selon la revendication 12, dans lequel :
le deuxième mécanisme de poussée (400) comporte une plaque supérieure (410) et une plaque inférieure (420) assemblées entre elles, la plaque supérieure (410) étant pourvue d'une lèvre supérieure (411), et la plaque inférieure (420) étant pourvue d'une lèvre inférieure (421) ;
l'extrémité arrière (111b) de la portion de préhension supérieure (111) du préhenseur (110) se trouve entre la lèvre supérieure (411) et la lèvre inférieure (421) ;
quand le deuxième mécanisme d'actionnement (500) actionne le deuxième mécanisme de poussée (400) pour le déplacer en arrière dans la deuxième direction (Y), la lèvre supérieure (411) pousse l'extrémité arrière (111b) de la portion de préhension supérieure (111) vers le bas de telle sorte que le préhenseur (110) est ouvert ;
quand le deuxième mécanisme d'actionnement (500) actionne le deuxième mécanisme de poussée (400) pour le déplacer vers l'avant dans la deuxième direction (Y), la lèvre inférieure (421) pousse l'extrémité arrière (111b) de la portion de préhension supérieure (111) vers le haut de telle sorte que le préhenseur (110) est fermé.

14. Système de préhension selon la revendication 13, dans lequel :
une surface inclinable du haut (1101) et une surface inclinable du bas (1102) sont formées sur l'extrémité arrière (111b) de la portion de préhension supérieure (111) ;
la lèvre supérieure (411) est adaptée pour pousser contre la surface inclinable du haut (1101) de la portion de préhension supérieure (111) et pour coulisser le long de la surface inclinable du haut (1101) ;
la lèvre inférieure (421) est adaptée pour pousser contre la surface inclinable du bas (1102) de la portion de préhension supérieure (111) et pour coulisser le long de la surface inclinable du bas (1102).
